# EUROPEAN PATENT APPLICATION

(11) **EP 4 053 631 A1**
(43) Date of publication of application: **07.09.2022**
(21) Application number: 20883438.2
(22) Date of filing: 16.10.2020
(51) Int. Cl.: G03F 1/24, G03F 1/82, C23C 16/30, C23C 16/34, C23C 16/40, C23C 16/42

(54) **REFLECTIVE MASK AND PRODUCTION METHOD FOR REFLECTIVE MASK**

(30) Priority: 01.11.2019 JP 2019199941
(71) Applicant: TOPPAN INC., Tokyo 110-0016 (JP)
(72) Inventor: ICHIKAWA, Kenjiro, Tokyo 110-0016 (JP); GODA, Ayumi, Tokyo 110-0016 (JP); NAKANO, Hideaki, Tokyo 110-0016 (JP)
(74) Representative: Hoffmann Eitle
(86) International application number: PCT/JP2020/039173
(87) International publication number: WO 2021/085192

(57) **Abstract**

There are provided a reflective mask having a coating film uniformly formed along the outermost surface and the side surfaces of a transfer pattern, having high EUV transmittance, and having high cleaning resistance and a production method therefor. To achieve the object, for example, a reflective mask (100) includes: a substrate (1); a multilayer reflective film (2) formed on the substrate (1) and reflecting an incident EUV light; an absorption layer (4) formed on at least a part of the multilayer reflective film (2) and absorbing the incident EUV light; and a coating film (5) formed on the multilayer reflective film (2) and on the absorption layer (4) and transmitting the incident EUV light, in which the coating film (5) has an extinction coefficient k of 0.04 or less to the EUV light, is resistant to cleaning with a cleaning chemical solution, and is formed with a uniform film thickness on the surface and the side surfaces of the absorption layer (4).

## Description

### Technical Field

The present invention relates to a reflective mask and a production method for the reflective mask.

### Background Art

In a production process for semiconductor devices, a demand for miniaturization by a photolithography technology has increased with the miniaturization of the semiconductor devices. In the photolithography, the minimum resolution dimension of a transfer pattern largely depends on the wavelength of an exposure light source, and the minimum resolution dimension can be made smaller as the wavelength is shorter. Therefore, in the production process for semiconductor devices, a conventional exposure light source using an ArF excimer laser light having a wavelength of 193 nm has been replaced with an extreme ultraviolet (EUV) exposure light source having a wavelength of 13.5 nm.

Due to the short wavelength of the EUV light, most substances have high light absorptivity. Therefore, a photomask for EUV (EUV mask) is a reflective mask, unlike a conventional transmissive mask. A reflective mask blank, which is the origin for the reflective mask, includes a multilayer reflective layer exhibiting high reflectance to an exposure light source wavelength and an absorption layer having the exposure light source wavelength, which are sequentially formed on a low thermal expansion substrate and further includes a back surface conductive film for an electrostatic chuck in an exposure machine formed on the back surface of a substrate. Further, an EUV mask having a structure having a buffer layer between a multi-layer reflective layer and an absorption layer is also mentioned.

When the reflective mask blank is processed to the reflective mask, the absorption layer is partially removed by electron beam (EB) lithography and an etching technology, and, in the case of a structure having a buffer layer, the buffer layer is also similarly partially removed, thereby forming a circuit pattern containing an absorption portion and a reflective portion in some cases. An optical image reflected by the reflective mask thus produced is transferred onto a semiconductor substrate via a reflective optical system.

Further, in the EUV lithography, a dioptric system utilizing light transmission cannot be used as described above, and therefore an optical system member of the exposure machine is not a lens but a mirror. This poses a problem that an incident light on the EUV mask and a reflected light on the EUV mask cannot be coaxially designed. In general, the EUV lithography uses a technique of making the EUV light incident by tilting the optical axis by 6° from the vertical direction of the EUV mask and irradiating a semiconductor substrate with a reflected light reflected at an angle of -6°.

As described above, the optical axis is tilted in the EUV lithography, and therefore the EUV light incident on the EUV mask creates a shadow of the circuit pattern of the EUV mask, sometimes causing a problem referred to as a so-called "shadowing effect" in which the transfer performance deteriorates. The circuit pattern formed on the EUV mask described above is a pattern also referred to as a transfer pattern or an absorption layer pattern.

To address the problem, PTL 1 discloses a method for reducing the shadowing effect by reducing the film thickness by adopting a conventional compound material having high absorptivity (extinction coefficient) to the EUV light for an absorption layer or a phase shift film containing Ta as main component.

Further, when the photomask is highly reactive to an acidic or alkaline cleaning chemical solution, the photomask cannot withstand repeated cleaning, shortening the life of the photomask. Therefore, the photomask needs to be formed of a compound material having high acid/alkali cleaning resistance (hereinafter, also simply referred to as "cleaning resistance").

However, the method in PTL 1 uses an absorption layer having two or more different compositions containing Ta as a main component but the cleaning resistance is not described.

According to a method in PTL 2, a method for improving the cleaning resistance of an absorption layer by forming an outermost surface protective layer containing a component containing Ta and O on an absorption layer containing Ta, Cr, and Pd as a main component is disclosed. However, PTL 2 does not describe the protection of an absorption layer sidewall in the formation of a transfer pattern, and thus the cleaning resistance, including the cleaning resistance of the sidewall, is not clarified. When the absorption layer contains substances other than the substances above as a main component, the cleaning resistance is naturally different between the absorption layer and an outermost surface portion. Therefore, the repeated cleaning of the photomask has sometimes posed a problem that the absorption layer sidewall is damaged because the absorption layer sidewall is unprotected and the pattern transferability is adversely affected.

In the technical field of an optical mask instead of the EUV mask, a protective film is formed on a transfer pattern for the purpose of physical protection in a contact exposure of the optical mask with a stepper in a method in PTL 3. Similarly thereto, it is conceivable that the cleaning resistance can be improved by forming a protective film on a transfer pattern. However, in the field of the EUV mask, the formation of the protective film on a multilayer film sometimes poses a problem that the pattern transferability decreases due to the absorption of the EUV light by the protective film. Therefore, there is a necessity of selecting a material with high transmittance to the EUV light as the protective film. Further, when the film thickness of the protective film varies in each pattern, there is a possibility that the transferability is adversely affected. Therefore, there is a necessity of uniformly forming the protective film along the surface and the side surfaces of the transfer pattern.

### Citation List

### Patent Literature

PTL 1: JP 2007-273678 A
PTL 2: JP 2014-45075 A
PTL 3: JP 60-87327 A

### Summary of Invention

### Technical Problem

As described above, the repeated use of the EUV mask requires the cleaning resistance of the outermost surface layer in the EUV mask. To achieve the cleaning resistance, it is effective to form a protective film on the outermost surface layer and the side surfaces of the transfer pattern formed on the EUV mask. However, when the protective film is formed of a protective film material with low EUV light transmittance, the shadowing effect sometimes adversely affects the pattern transferability. Further, when the protective film is not uniformly formed on the outermost surface layer and the side surfaces of the transfer pattern, there is a possibility that the pattern transferability deteriorates. More specifically, few conventional protective films of the EUV mask have had both high EUV transmittance and high cleaning resistance.

Thus, it is an object of the present invention to provide a reflective mask having a coating film uniformly formed along the outermost surface and the side surfaces of a transfer pattern, having high EUV transmittance, and having high cleaning resistance and a production method therefor.

### Solution to Problem

To achieve the above-described object, a reflective mask according to one aspect of the present invention includes: a substrate; a reflective portion formed on the substrate and reflecting an incident light; an absorption portion formed on at least a part of the reflective portion and absorbing the incident light; and a coating film formed on the reflective portion and the absorption portion and transmitting the incident light, in which the coating film has an extinction coefficient k of 0.04 or less to an extreme ultraviolet (EUV: wavelength of 13.5 nm) light, is resistant to cleaning with a cleaning chemical solution, and is formed with a uniform film thickness on the outermost surface and the side surfaces of the absorption portion.

### Advantageous Effects of Invention

According to the present invention, by uniformly coating the outermost surface layer and the side surfaces of the absorption portion with a material having high EUV transmittance and high cleaning resistance, the dimensional accuracy and the shape accuracy of a pattern to be transferred onto a wafer can be maintained and the mask can be used for a long period of time.

### Brief Description of Drawings

FIG. 1 is a schematic cross-sectional view illustrating the structure of a reflective mask according to an embodiment of the present invention;
FIG. 2 is a schematic cross-sectional view illustrating the structure of a reflective mask blank according to Examples of the present invention;
FIG. 3 is a schematic cross-sectional view illustrating a step of producing a reflective mask according to Examples of the present invention;
FIG. 4 is a schematic cross-sectional view illustrating a step of producing the reflective mask according to Examples of the present invention;
FIG. 5 is a schematic plan view illustrating the shape of a design pattern of the reflective mask according to Examples of the present invention; and
FIG. 6 is a schematic cross-sectional view illustrating the structure of the reflective mask according to Examples of the present invention.

### Description of Embodiments

An embodiment of the present invention will now be described below with reference to the drawings.

### (Entire structure)

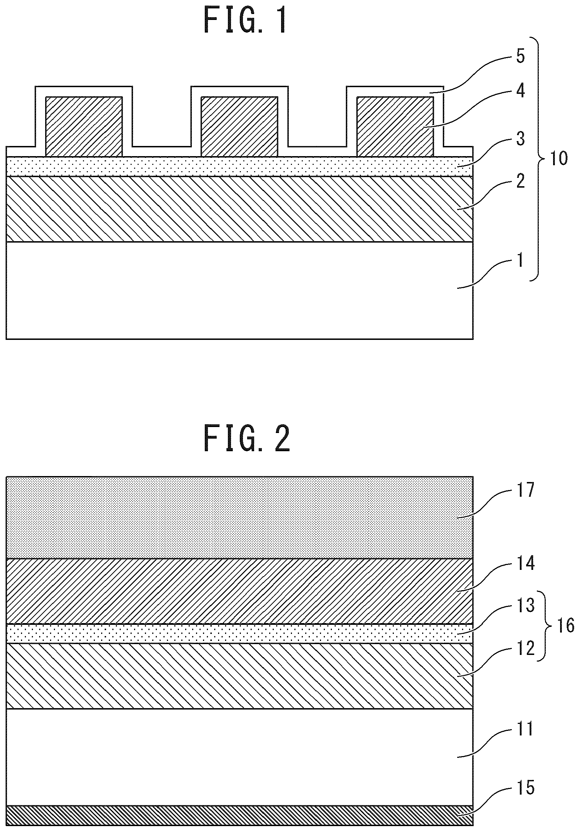

FIG. 1 is a schematic cross-sectional view illustrating the configuration of a reflective photomask with a coating film (hereinafter, also simply referred to as "reflective mask") 10.

The reflective mask 10 includes a substrate 1, a multilayer reflective film (reflective portion) 2, a capping layer 3, an absorption layer (absorption portion) 4, and a coating film 5. The reflective mask 10 includes an absorption layer pattern (transfer pattern), which is a fine pattern formed by the absorption layer 4.

The substrate 1 according to this embodiment is a low thermal expansion substrate, for example. Specifically, a flat Si substrate, synthetic quartz substrate, or the like is usable as the substrate 1. Further, a low thermal expansion glass to which titanium is added is usable as the substrate 1. As described above, the substrate 1 may be any material having a small thermal expansion coefficient and is not limited to these materials.

### (Multilayer reflective film)

The multilayer reflective film 2 according to this embodiment is a film (layer) formed on the substrate 1. This multilayer reflective film 2 is a film for reflecting an EUV light (extreme ultraviolet light), which is an exposure light and is a multilayer reflective film containing a combination of materials having greatly different refractive indices to the EUV light, for example. The multilayer reflective film 2 is preferably a film formed by repeatedly depositing a multilayer film in which a layer containing Mo (molybdenum) and a layer containing Si (silicon) are deposited or a multilayer film in which a layer containing Mo (molybdenum) and a layer containing Be (beryllium) are deposited by about 40 cycles, for example.

### (Capping layer)

The capping layer 3 according to this embodiment is a layer formed on the multilayer reflective film 2. The capping layer 3 is formed of a material resistant to dry etching performed in forming the absorption layer 4. More specifically, the capping layer 3 functions as an etching stopper to prevent damage to the multilayer reflective film 2 when the transfer pattern (low reflection portion pattern) is formed by etching the absorption layer 4. Herein, the capping layer 3 may not be provided depending on materials of the multilayer reflective film 2 and the etching conditions.

### (Absorption layer)

The absorption layer 4 according to this embodiment is preferably formed of a simple substance material, such as tantalum, tin, indium, nickel, osmium, hafnium, tungsten, platinum, tellurium, cobalt, or palladium, or a compound material, such as oxide or nitride, containing at least one of the elements mentioned above, for example. The material itself constituting the absorption layer 4 preferably contains the elements mentioned above in an atomic number ratio of 50% or more.

The absorption layer 4 preferably contains the compound material containing the elements mentioned above in a proportion of 50% by mass or more based on the total mass of the absorption layer 4.

In the case of the absorption layer 4 formed of the materials mentioned above, the transfer pattern formed by the absorption layer 4 can reduce (suppress) a shadowing effect.

The layer thickness of the absorption layer 4 may be within the range of 10 nm or more and 50 nm or less and is more preferably within the range of 20 nm or more and 40 nm or less and still more preferably within the range of 25 nm or more and 35 nm or less. When the layer thickness of the absorption layer 4 is within the ranges above, the EUV light can be effectively absorbed and a reduction in thickness of the absorption layer 4 can be realized.

### (Coating film)

The absorption layer 4 needs to have the cleaning resistance as a reflective mask, and thus material species are limited. However, by coating the absorption layer 4 with the coating film 5 having high cleaning resistance, a material having a poor cleaning resistance is also usable as a constituent material of the absorption layer 4. Further, even when the constituent material of the absorption layer 4 is a material having the cleaning resistance, the absorption layer 4 does not come into direct contact with a chemical solution by being protected by the coating film 5, and therefore can further withstand repeated cleaning.

As the cleaning resistance required for the reflective mask, the film reduction amount of the transfer pattern (low reflective portion pattern) is measured with an electrobalance when the reflective mask 10 is dipped in sulfuric acid at 80°C for 10 minutes, and then dipped in a cleaning tank filled with a cleaning chemical solution obtained by mixing ammonia, hydrogen peroxide water, and water in a ratio of 1:1:20 (mass ratio) for 10 minutes using 500 W megasonic waves, and a compound material with no mass changes is used as a material with high cleaning resistance in this embodiment. Herein, the "no mass changes" means that the film reduction amount (mass) is 10% or less based on the total mass of the transfer pattern (low reflective portion pattern).

In the case of the reflective mask 10 according to this embodiment, the coating film 5 serves as the outermost surface layer in the reflective mask 10, and therefore it is preferable that the coating film 5 does not interfere with an optical path of each of the incident light and the reflected light. In order to keep a deterioration of the resolution due to the shadowing effect within 25%, it is desirable that the extinction coefficient k of the coating film 5 serving as the outermost surface layer is 0.04 or less and the film thickness of coating film 5 is within 10 nm. The range of the film thickness of the coating film 5 is more preferably within the range of 1 nm or more and 8 nm or less and still more preferably within the range of 2 nm or more and 6 nm or less. When the range is within the numerical ranges above, the interference with the optical path of each of the incident light and the reflected light can be further reduced.

A main material of the coating film 5 for reducing the shadowing effect is preferably a compound material having a small extinction coefficient k to the EUV light so as not to interfere with the optical paths. For example, the extinction coefficient k of silicon (Si) is 0.0018, which satisfies the above-described conditions. In addition, silicon dioxide is known to have high acid/alkali resistance. The application of silicon dioxide to the outermost surface layer can achieve the cleaning resistance required for the reflective mask 10. Further, a compound material having an atomic number ratio between silicon (Si) and oxygen (O) of 1:1.5 to 1:2, having a total content of silicon and oxygen of 50% atom or more of the entire compound material, and satisfying the above-described optical conditions has sufficient cleaning resistance, and therefore is preferable as the main material of the coating film 5.

As described above, the coating film 5 is preferably a compound material having the cleaning resistance and an extension coefficient k of 0.04 or less. Therefore, the coating film 5 may be formed of a simple substance material, such as silicon dioxide, silicon nitride, aluminum oxide, ruthenium, zirconium, chromium, hafnium, niobium, rhodium, tungsten, vanadium, or titanium, or a compound material, such as an oxide or a nitride, containing at least one of the elements above, for example. The material itself constituting the coating film 5 preferably contains the elements mentioned above in an atomic number ratio of 50% or more.

The coating film 5 preferably contains the compound material containing the elements mentioned above in a proportion of 50% by mass or more based on the total mass of the coating film 5.

In the case of the coating film 5 formed of the material described above, the transfer pattern formed by the coating film 5 can enhance the absorption efficiency of the EUV light.

Although not illustrated in FIG. 1, in the reflective mask 10 according to this embodiment, a back surface conductive film can be formed on the surface opposite to the surface on which the multilayer reflective film 2 is formed of the substrate 1. The back surface conductive film is a film for fixing the reflective mask 10 utilizing the principle of an electrostatic chuck when the reflective mask 10 is installed in an exposure machine.

### (Method for forming coating film)

When producing the reflective mask 10 according to this embodiment, the coating film 5 may be formed using an atomic layer deposition method including alternately supplying a gas containing at least one of silicon, aluminum, zirconium, ruthenium, chromium, hafnium, niobium, rhodium, tungsten, vanadium, and titanium and a gas containing at least one of oxygen, nitrogen, or fluorine.

The atomic layer deposition method can form a thin film on an atomic layer basis. Therefore, the coating film 5 formed by this method has high film thickness uniformity and high shape followability.

The coating film 5 needs to be formed on the surface and the side surfaces of the absorption layer 4 and further along the transfer pattern formed on the capping layer 3 or the multilayer reflective film 2, i.e., on the capping layer 3 or on the multilayer reflective film 2 having an exposed surface, in order to prevent a deterioration of the transfer performance by cleaning. Further, in order to prevent a deterioration of the transferability by the coating film 5 as described above, the allowable film thickness is limited, and the coating film 5 to be formed is required to have a uniform film thickness. Therefore, the formation of the coating film 5 by the atomic layer deposition method having excellent film thickness uniformity and shape followability enables the production of the reflective mask 10 having high cleaning resistance without the deterioration of the pattern transferability. Herein, the "uniform film thickness" means that the thickness of the thinnest part is within the range of -2 nm and the thickness of the thickest part is within the range of +2 nm to the average thickness of the coating film 5 formed on each of the surface and the side surfaces of the absorption layer 4. More specifically, in this embodiment, the layer thickness of the coating film 5 formed on the surface of the absorption layer 4 is kept within the range of ±2 nm to the average thickness of the coating film 5. The layer thickness of the coating film 5 formed on the side surfaces of the absorption layer 4 is kept within the range of ±2 nm to the average thickness of the coating film 5.

As described above, in the reflective mask 10 according to this embodiment, the coating film 5 having high cleaning resistance is formed on the surface and the side surfaces of the absorption layer 4 by the atomic layer deposition method. Therefore, the erosion or the like of the absorption layer 4 with a cleaning chemical solution used for the reflective mask 10 can be reduced and the deterioration of the pattern transferability can be suppressed.

Further, the coating film 5 is uniformly formed of a material having high EUV transmittance, and therefore a deterioration of the transferability due to the formation of the coating film 5 can be suppressed. Therefore, even when an absorption layer material having low cleaning resistance is used, high pattern transfer accuracy can be realized.

### [Example 1]

Hereinafter, a reflective mask according to Examples of the present invention is described with reference to the drawings and tables.

As illustrated in FIG. 2, a multilayer reflective film 12 formed by depositing 40 multilayer films containing a pair of silicon (Si) and molybdenum (Mo) on a synthetic quartz substrate 11 having a low thermal expansion property. The film thickness of the multilayer reflective film 12 was set to 280 nm. In FIG. 2, the multilayer reflective film 12 is illustrated as several pairs of multilayer films, for convenience.

Next, a capping layer 13 formed of ruthenium (Ru) as an intermediate film was formed on the multilayer reflective film 12 so as to have a film thickness of 2.5 nm. Thus, a reflective layer (reflective portion) 16 having the multilayer reflective film 12 and the capping layer 13 is formed on the substrate 11.

An absorption layer 14 formed of tin oxide was formed on the capping layer 13 so as to have a film thickness of 26 nm.

Next, a back surface conductive film 15 formed of chromium nitride (CrN) was formed with a thickness of 100 nm on the side on which the multilayer reflective film 12 was not formed of the substrate 11.

A multi-source sputtering apparatus was used for the formation of each film on the substrate 11. The film thickness of each film was controlled by a sputtering time.

Next, a positive chemically amplified resist (SEBP9012: manufactured by Shin-Etsu Chemical Co., Ltd.) was formed with a film thickness of 120 nm on the absorption layer 14 by spin coating and baked at 110°C for 10 minutes to form a resist film 17.

Subsequently, a predetermined pattern was drawn on the positive chemically amplified resist using an electron beam lithography system (JBX3030: manufactured by JEOL Ltd.).

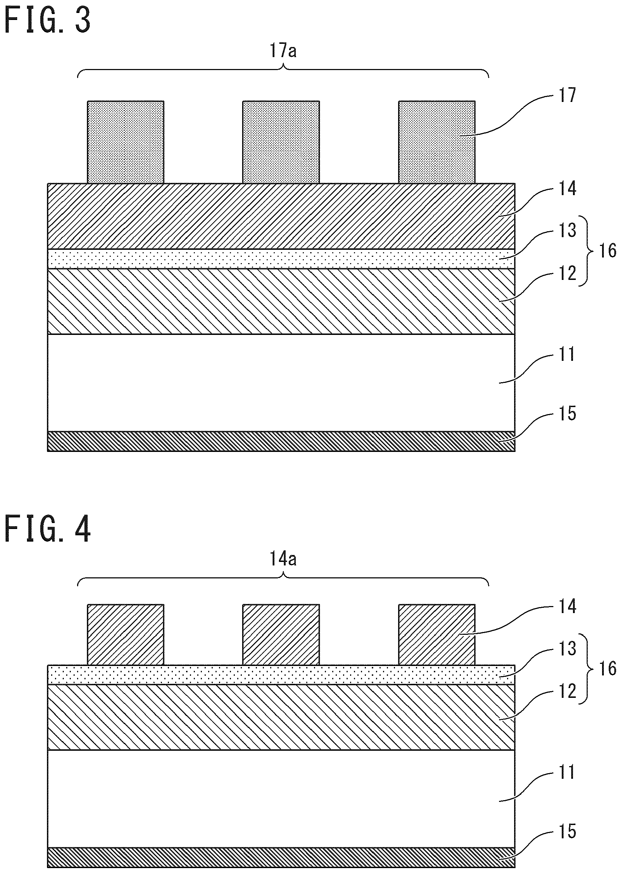

Thereafter, baking treatment was applied at 110°C for 10 minutes, and then spray-development (SFG3000: manufactured by SIGMAMELTEC LTD.) was performed. Thus, a resist pattern 17a was formed as illustrated in FIG. 3.

Next, the absorption layer 14 was patterned by dry etching mainly containing a chlorine gas using the resist pattern as an etching mask to form an absorption layer pattern 14a.

Next, the remaining resist pattern 17a was peeled off. Thus, as illustrated in FIG. 4, the absorption layer pattern 14a was formed in which the surface and the side surfaces of the absorption layer 14 were exposed.

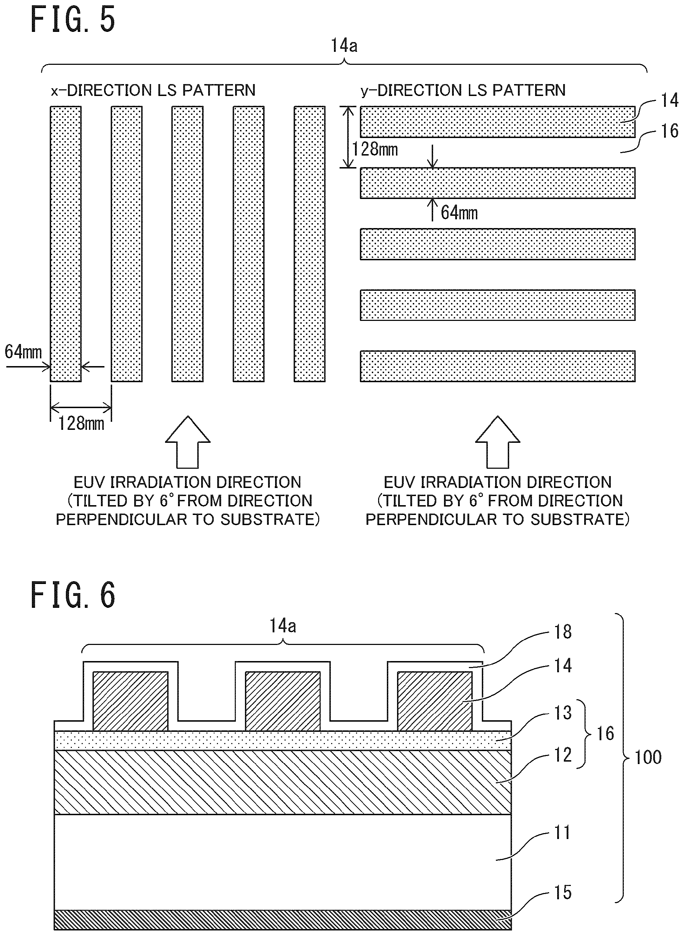

In this example, the absorption layer pattern 14a formed by the absorption layer 14 functioning as a low reflective layer was set to an LS (line and space) pattern with a line width of 64 nm. The LS pattern with a line width of 64 nm was designed in each of the x-direction and the y-direction as illustrated in FIG. 5 so that the effect of the shadowing effect by EUV irradiation was able to be easily viewed.

Next, a coating film 18 formed of silicon dioxide was formed on the exposed surface and the side surfaces of the absorption layer 14 and on the reflective layer 16 by an atomic layer deposition method using a silicon gas and an oxygen gas so as to have a film thickness of 2 nm, 5 nm, and 10 nm, respectively. The atomic number ratio between silicon and oxygen was 1:1.9 as measured by XPS (X-ray photoelectron spectroscopy). Thus, a reflective photomask (hereinafter, also simply referred to as "reflective mask") 100 as illustrated in FIG. 6 was produced.

### [Example 2]

The absorption layer pattern 14a illustrated in FIG. 4 was formed in the same manner as in Example 1.

Next, the coating film 18 formed of aluminum oxide was formed on the surface and the side surfaces of the absorption layer 14 and on the reflective layer 16 so as to have a film thickness of 2 nm, 5 nm, and 10 nm, respectively, by the atomic layer deposition method using an organic aluminum gas and an oxygen gas. The atomic number ratio between aluminum and oxygen was 1:1.6 as measured by XPS (X-ray photoelectron spectroscopy). Thus, a reflective mask 100 as illustrated in FIG. 6 was produced.

### [Example 3]

The absorption layer pattern 14a illustrated in FIG. 4 was formed in the same manner as in Example 1.

Next, the coating film 18 formed of titanium oxide was formed on the surface and the side surfaces of the absorption layer 14 and on the reflective layer 16 so as to have a film thickness of 2 nm, 5 nm, and 10 nm, respectively, by the atomic layer deposition method using an organic titanium gas and an oxygen gas. Thus, a reflective mask 100 as illustrated in FIG. 6 was produced.

### [Comparative Example 1]

The absorption layer pattern 14a illustrated in FIG. 4 was formed in the same manner as in Example 1.

Next, the coating film 18 formed of molybdenum was formed on the surface and the side surfaces of the absorption layer 14 and on the reflective layer 16 so as to have a film thickness of 2 nm, 5 nm, and 10 nm, respectively, by the atomic layer deposition method using an organic molybdenum gas. Thus, a reflective mask 100 as illustrated in FIG. 6 was produced.

### [Comparative Example 2]

The absorption layer pattern 14a illustrated in FIG. 4 was formed in the same manner as in Example 1.

Next, the coating film 18 formed of platinum was formed on the surface and the side surfaces of the absorption layer 14 and on the reflective layer 16 so as to have a film thickness of 2 nm, 5 nm, and 10 nm, respectively, by the atomic layer deposition method using an organic platinum gas. Thus, a reflective mask 100 as illustrated in FIG. 6 was produced.

In Examples and Comparative Examples described above, the film thickness of the coating film 18 was measured by a transmission electron microscope.

### (Cleaning resistance)

The reflective mask 100 was cleaned using SPM cleaning using warm sulfuric acid and hydrogen peroxide water at a weight concentration of 90% and a liquid temperature of 80°C and SC1 cleaning using ammonia water and hydrogen peroxide water. The confirmation of the film reduction was determined from mass changes by an electrobalance. In this example, when the film reduction amount is 10% or less of the mass of the coating film 18, there are no problems in use, which was evaluated as "Having cleaning resistance". On the other hand, when the film reduction amount exceeds 10% of the mass of the coating film 18, there is a problem in use, which was evaluated as "Having no cleaning resistance".

### (Wafer exposure evaluation)

Using an EUV exposure apparatus (NXE3300B: manufactured by ASML), the absorption layer pattern 14a of the reflective mask 100 produced in each of Examples and Comparative Examples was transferred and exposed on a semiconductor wafer coated with an EUV positive chemically amplified resist. At this time, the exposure amount was adjusted so that the x-direction LS pattern illustrated in FIG. 5 was transferred as designed. The observation and the line width measurement of the resist pattern transferred by an electron beam dimension measuring device were carried out, and the resolution was confirmed. More specifically, in this example, the confirmation of the resolution was evaluated based on whether the y-direction LS pattern was appropriately transferred. More specifically, in a state where the exposure conditions were adjusted so that the x-direction LS pattern illustrated in FIG. 5 was transferred as designed, a case where a deterioration of the resolution was kept within 25% to the resolution without the coating film for the y-direction LS pattern was evaluated as "Pass" and a case where the deterioration of the resolution exceeded 25% (when the y-direction LS pattern was not resolved) to the resolution without the coating film for the y-direction LS pattern was evaluated as "Fail". In Tables 1 to 5, a case where the y-direction LS pattern was not resolved was indicated by "-".

These evaluation results are shown in Tables 1 to 5.

Table 1 shows the cleaning resistance and the resist pattern dimension on the wafer for the reflective mask 100 of Example 1, i.e., the reflective mask 100 in which the absorption layer 14 was formed of tin oxide, the film thickness of the absorption layer 14 was 26 nm, the coating film 18 was formed of silicon dioxide, and the film thicknesses of the coating film 18 were 2 nm, 5 nm, and 10 nm, respectively.

In the reflective mask 100 of Example 1, no film reduction due to cleaning was confirmed. More specifically, the reflective mask 100 of Example 1 had the cleaning resistance. When the film thicknesses of the coating film 18 were 2 nm, 5 nm, and 10 nm, the LS pattern dimensions in the y-direction were 12.4 nm, 11.9 nm, and 11.7 nm, respectively, to a designed value of 16.0 nm. As described above, a deterioration of the dimensional accuracy due to the shadowing effect was observed as the film thickness of the coating film 18 increased, but the deterioration of the resolution was kept within about 25%. More specifically, the reflective mask 100 of Example 1 had pattern transferability causing no problems in use.

**[Table 1]**

| Absorption layer | | Coating film | | Cleaning resistance | Dimension | |
|---|---|---|---|---|---|---|
| Material | Film thickness | Material | Film thickness | | X-direction | Y-direction |
| Tin oxide (n: 0.94, k: 0.07) | 26 nm | Silicon dioxide (n: 0.98, k: 0.01) | 2 nm | Having cleaning resistance | 16.0 nm | 12.4 nm |
| | | | 5 nm | Having cleaning resistance | 16.0 nm | 11.9 nm |
| | | | 10 nm | Having cleaning resistance | 16.0 nm | 11.7 nm |

Table 2 shows the cleaning resistance and the resist pattern dimension on the wafer for the reflective mask 100 of Example 2, i.e., the reflective mask 100 in which the absorption layer 14 was formed of tin oxide, the film thickness of the absorption layer 14 was 26 nm, the coating film 18 was formed of aluminum oxide, and the film thicknesses of the coating film 18 were 2 nm, 5 nm, and 10 nm, respectively.

In the reflective mask 100 of Example 2, no film reduction due to cleaning was confirmed. More specifically, the reflective mask 100 of Example 2 had the cleaning resistance. When the film thicknesses of the coating film 18 were 2 nm, 5 nm, and 10 nm, the LS pattern dimensions in the y-direction were 12.3 nm, 11.5 nm, and 10.4 nm, respectively, to a designed value of 16.0 nm, and the results equivalent to the results of Example 1 were obtained. As described above, the deterioration of the dimensional accuracy due to the shadowing effect was observed as the film thickness of the coating film 18 increased, but the deterioration of the resolution was kept within about 25% as with Example 1. More specifically, the reflective mask 100 of Example 2 had pattern transferability causing no problems in use.

**[Table 2]**

| Absorption layer | | Coating film | | Cleaning resistance | Dimension | |
|---|---|---|---|---|---|---|
| Material | Film thickness | Material | Film thickness | | X-direction | Y-direction |
| Tin oxide (n: 0.94, k: 0.07) | 26 nm | Aluminum oxide (n: 0.97, k: 0.04) | 2 nm | Having cleaning resistance | 16.0 nm | 12.3 nm |
| | | | 5 nm | Having cleaning resistance | 16.0 nm | 11.5 nm |
| | | | 10 nm | Having cleaning resistance | 16.0 nm | 10.4 nm |

Table 3 shows the cleaning resistance and the resist pattern dimension on the wafer for the reflective mask 100 of Example 3, i.e., the reflective mask 100 in which the absorption layer 14 was formed of tin oxide, the film thickness of the absorption layer 14 was 26 nm, the coating film 18 was formed of titanium oxide, and the film thicknesses of the coating film 18 were 2 nm, 5 nm, and 10 nm.

In the reflective mask 100 of Example 3, no film reduction due to cleaning was confirmed. More specifically, the reflective mask 100 of Example 3 had the cleaning resistance. When the film thicknesses of the coating film 18 were 2 nm, 5 nm, and 10 nm, the LS pattern dimensions in the y-direction were 12.5 nm, 11.2 nm, and 10.5 nm, respectively, to a designed value of 16.0 nm, and the results equivalent to the results of Example 1 were obtained. As described above, the deterioration of the dimensional accuracy due to the shadowing effect was observed as the film thickness of the coating film 18 increased, but the deterioration of the resolution was kept within about 25% as with Example 1. More specifically, the reflective mask 100 of Example 3 had pattern transferability causing no problems in use.

**[Table 3]**

| Absorption layer | | Coating film | | Cleaning resistance | Dimension | |
|---|---|---|---|---|---|---|
| Material | Film thickness | Material | Film thickness | | X-direction | Y-direction |
| Tin oxide (n: 0.94, k: 0.07) | 26 nm | Titanium oxide (n: 0.97, k: 0.02) | 2 nm | Having cleaning resistance | 16.0 nm | 12.5 nm |
| | | | 5 nm | Having cleaning resistance | 16.0 nm | 11.2 nm |
| | | | 10 nm | Having cleaning resistance | 16.0 nm | 10.5 nm |

Table 4 shows the cleaning resistance and the resist pattern dimension on the wafer for the reflective mask 100 of Comparative Example 1, i.e., the reflective mask 100 in which the absorption layer 14 was formed of tin oxide, the film thickness of the absorption layer 14 was 26 nm, the coating film 18 was formed of molybdenum, and the film thicknesses of the coating film 18 were 2 nm, 5 nm, and 10 nm.

In the reflective mask 100 of Comparative Example 1, the film reduction due to the cleaning chemical solution was confirmed, which showed that the cleaning resistance was low. When the film thicknesses of the coating film 18 were 2 nm, 5 nm, and 10 nm, the LS pattern dimensions in the y-direction were 12.7 nm, 11.1 nm, and 10.5 nm, respectively, to a designed value of 16.0 nm, and the results equivalent to the results of Examples 1 to 3 were obtained. As described above, the deterioration of the dimensional accuracy due to the shadowing effect was observed as the film thickness of the coating film 18 increased as with Examples 1 to 3. On the other hand, unlike Examples 1 to 3, the coating film 18 formed of molybdenum is not suitable for use as a reflective mask because the material has low cleaning resistance.

**[Table 4]**

| Absorption layer | | Coating film | | Cleaning resistance | Dimension | |
|---|---|---|---|---|---|---|
| Material | Film thickness | Material | Film thickness | | X-direction | Y-direction |
| Tin oxide | 26 nm | Molybdenum | 2 nm | Not having cleaning resistance | 16.0 nm | 12.7 nm |
| (n: 0.94, k: 0.07) | | (n: 0.92, k: 0.01) | 5 nm | Not having cleaning resistance | 16.0 nm | 11.1 nm |
| | | | 10 nm | Not having cleaning resistance | 16.0 nm | 10.5 nm |

Table 5 shows the cleaning resistance and the resist pattern dimension on the wafer for the reflective mask 100 of Comparative Example 2, i.e., the reflective mask 100 in which the absorption layer 14 was formed of tin oxide, the film thickness of the absorption layer 14 was 26 nm, the coating film 18 was formed of platinum, and the film thicknesses of the coating film 18 were 2 nm, 5 nm, and 10 nm.

In the reflective mask 100 of Comparative Example 2, no film reduction due to cleaning was confirmed. When the film thickness of the coating film 18 was 2 nm, the LS pattern dimension in the y-direction was 12.4 nm to a designed value of 16.0 nm but the pattern was not resolved when the film thicknesses of the coating film 18 were 5 nm and 10 nm. More specifically, the reflective mask 100 of Comparative Example 2 did not have sufficient pattern transferability.

As described above, unlike Examples 1 to 3, when the coating film 18 was formed of a material having a large extension coefficient k, the shadowing effect strongly appeared as the film thickness of the coating film 18 increased, and the y-direction pattern was not resolved when the film thickness was 5 nm or more.

**[Table 5]**

| Absorption layer | | Coating film | | Cleaning resistance | Dimension | |
|---|---|---|---|---|---|---|
| Material | Film thickness | Material | Film thickness | | X-direction | Y-direction |
| Tin oxide (n: 0.94, k: 0.07) | 26 nm | Platinum (n: 0.89, k: 0.06) | 2 nm | Having cleaning resistance | 16.0 nm | 12.4 nm |
| | | | 5 nm | Having cleaning resistance | 16.0 nm | - |
| | | | 10 nm | Having cleaning resistance | 16.0 nm | - |

The results above showed that, in the case of the reflective mask 100 in which, even when the absorption layer 14 contains a material with poor cleaning resistance, the coating film 18 is formed of silicon dioxide, aluminum oxide, and titanium oxide, the shadowing effect does not deteriorate and the cleaning resistance is good, and therefore the reflective mask 100 having a long life and high transfer performance is obtained.

The reflective mask according to the present invention can be suitably used for forming a fine pattern by the EUV exposure in a step of producing a semiconductor integrated circuit or the like.

### Reference Signs List

- 1: substrate
- 2: multilayer reflective film
- 3: capping layer
- 4: absorption layer
- 5: coating film
- 10: reflective photomask
- 11: substrate
- 12: multilayer reflective film
- 13: capping layer
- 14: absorption layer
- 14a: absorption layer pattern
- 15: back surface conductive film
- 16: reflective portion (reflective layer)
- 17: resist film
- 17a: resist pattern
- 18: coating film
- 100: reflective photomask

## Claims

1. A reflective mask comprising:
a substrate;
a reflective portion formed on the substrate and reflecting an incident light;
an absorption portion formed on at least a part of the reflective portion and absorbing the incident light; and
a coating film formed on the reflective portion and the absorption portion and transmitting the incident light, wherein
the coating film has an extinction coefficient k of 0.04 or less to an extreme ultraviolet (EUV: wavelength of 13.5 nm) light, is resistant to cleaning with a cleaning chemical solution, and is formed with a uniform film thickness on an outermost surface and side surfaces of the absorption portion.

2. The reflective mask according to claim 1, wherein the coating film is formed of a compound containing at least one of silicon dioxide, silicon nitride, aluminum oxide, ruthenium, zirconium, chromium, hafnium, niobium, rhodium, tungsten, vanadium, and titanium.

3. The reflective mask according to claim 1 or claim 2, wherein the absorption portion is formed of a compound containing at least one of tantalum, tin, indium, nickel, osmium, hafnium, tungsten, platinum, tellurium, cobalt, and palladium.

4. A production method for the reflective mask according to any one of claims 1 to 3, the method comprising:
forming the coating film by an atomic layer deposition method.

5. The production method for the reflective mask according to claim 4, wherein, in the formation of the coating film, the coating film is formed by the atomic layer deposition method using a metal hydride, a metal halide, or an organometallic compound as a material gas.
